# EUROPEAN PATENT APPLICATION

(11) **EP 4 270 786 A1**
(43) Date of publication of application: **01.11.2023**
(21) Application number: 22170963.7
(22) Date of filing: 29.04.2022
(51) Int. Cl.: H03K 3/537

(54) **A HIGH VOLTAGE PULSE GENERATOR A METHOD OF OPERATING A HIGH VOLTAGE PULSE GENERATOR**

(71) Applicant: VITO NV, 2400 Mol (BE)
(72) Inventor: COENEN, Peter, B-2400 Mol (BE); VAN DE POL, B-2400 Mol (BE); JANSSEN, Stijn, B-2400 Mol (BE); HEREMANS, Guido, B-2400 Mol (BE)
(74) Representative: V.O.

(57) **Abstract**

The invention relates to a Marx generator (1) comprising a circuit which includes at least two capacitors (C) which are arranged to be charged in parallel and to be discharged in series. The circuit comprises at least two spark gap switches (5), wherein each spark gap switch comprises two electrodes (7a, 7b) separated by a gap distance (G) which is filled with a pressurized gas (13), and wherein each spark gap switch (5) is configured to allow an electric spark to pass between its two electrodes in case a potential difference between said two electrodes exceeds a breakdown voltage, and wherein the Marx generator (1) includes an adjustment unit (10) which is configured to adjust the gap distance (G) between the two electrodes of each of the at least two spark gap switches such as to control the output voltage, wherein the adjustment unit (10) is configured to adjust the gap distance by means of a pressure controlled actuator and/or volume controlled actuator (12).

## Description

### FIELD OF THE INVENTION

The invention relates to a high voltage Marx generator. Furthermore, the invention relates to a method of operating a high voltage Marx generator. Furthermore, the invention relates to a controller or control system for a high voltage Marx generator and a computer program product. Additionally, the invention relates to a spark gap arrangement for a Marx generator. Further, the invention relates to a trigger/firing mechanism for a Marx generator. Also, the invention relates to a system including the Marx generator, such as for instance an electro-pulse drilling system.

### BACKGROUND TO THE INVENTION

A Marx generator is an electrical circuit for producing high voltage pulses. Such high voltage pulse generators have a particular circuit topology and are widely used in various applications. Conventionally, a Marx generator includes a plurality of stages (cf. circuit branches) each consisting of an energy storage capacitor and a switch. The capacitors are charged in parallel by a charging voltage and then discharged in series by means of the switches, producing a high voltage pulse. During discharge, the generator can deliver its energy to a load that can be resistive, inductive, and/or capacitive. The Marx generator is configured to generate high voltage pulses having voltages greater than the voltage of its power supply.

Typically, the Marx generator includes a plurality of capacitor stages. The spark gaps in the stages may operate in a self-breakdown mode. To each spark gap, except for the output spark gap, two charging branches are connected, one to each of the two connectors of the spark gap. As a result, there are altogether 2(n-1) charging branches associated with an n-stage Marx generator. With a charging voltage U at each of the stage capacitors at the output of the Marx generator, a voltage pulse with a peak value of n*U can be obtained at breakdown. For example, a 100 stage Marx Generator that is charged to 10 kV per stage can produce approximately 1,000 kV at the load. Likewise, a 10 stage Marx that is charged to 100 kV per stage will produce approximately the same voltage at the load.

The switches in the Marx generator are typically gas insulated spark gaps that are constructed of two principal electrodes. The Marx generator may comprise a housing in which an atmosphere of a dielectric gas prevails. The plurality of capacitor stages may be arranged in said housing.

The high voltage Marx generators may have numerous possible applications, such as for instance electro-pulse drilling. In electro-pulse drilling, a rock formation can be drilled using arcs generated by a Marx generator. However, often the surface to be drilled (e.g. rock formation) has inhomogeneous material properties, which can result in ineffective drilling.

There is a need to better control the output of the Marx generator. It is desired to be able to perform such control robustly and accurately, even if the Marx generator is located remotely (e.g. electro-pulse drill head). Additionally or alternatively, it is often desired to select the output of the Marx generator based on the input power supply.

### SUMMARY OF THE INVENTION

It is an object of the invention to provide for a method and a system that obviates at least one of the above mentioned drawbacks.

Additionally or alternatively, it is an object of the invention to improve the operation of the Marx generator.

Additionally or alternatively, it is an object of the invention to provide for a Marx generator with improved (voltage) output flexibility.

Additionally or alternatively, it is an object of the invention to improve the control of the output of the Marx generator .

Additionally or alternatively, it is an object of the invention to control the output of the Marx generator within a predetermined range at predetermined points in time in an effective and robust way.

Additionally or alternatively, it is an object of the invention to improve a self-breakdown of spark gaps in a Marx generator.

Additionally or alternatively, it is an object of the invention to prevent over-voltage and/or under-voltage breakdown of one or more spark gaps in a Marx generator.

Additionally or alternatively, it is an object of the invention to reduce wear generated by an over-voltage breakdown of one or more spark gaps.

Thereto, the invention provides for a Marx generator comprising a circuit which includes at least two capacitors which are arranged to be charged in parallel and to be discharged in series, wherein during discharge an output voltage is generated adding up a charging voltage of each of the at least two capacitors, wherein the circuit comprises at least two spark gap switches, wherein each spark gap switch comprises two electrodes separated by a gap distance which is filled with a pressurized gas, and wherein each spark gap switch is configured to allow an electric spark to pass between its two electrodes in case a potential difference between said two electrodes exceeds a breakdown voltage, and wherein the Marx generator includes an adjustment unit which is configured to adjust the gap distance between the two electrodes of each of the at least two spark gap switches such as to control the output voltage, wherein the adjustment unit is configured to adjust the gap distance by means of a pressure controlled actuator and/or volume controlled actuator.

The Marx generator is configured to enable active adjustment/setting of the electrode gap distance of spark gap switches by means of the pressure and/or volume controlled actuator. Such active control of the gap distance allows to robustly and accurately control the output of the Marx generator. Using a pressure/volume controlled actuator for mechanically adjusting the relative distance between electrode pairs of the spark gap switches of the Marx generator has significant advantages with respect to direct regulation of the pressure in the spark gap switches of the Marx generator. The pressure/volume actuator provides for more adjustment flexibility of the output of the Marx generator, whilst having an advantageous reliability and accuracy. The robust design of the pressure/volume controlled actuator enables its use in Marx generator even under harsh conditions. The output voltage of the Marx generator can be better remotely steered, maintained, set and/or adapted. Furthermore, the pressure/volume actuator may be free of electronic components, thereby allowing for a reliable operation near the spark gap switches.

Optionally, the adjustment unit comprises at least one of a pressure control module or a volume control module, wherein the pressure control module is configured to operate the pressure controlled actuator such as to steer a fluid actuation pressure for achieving adjustment of the gap distance, wherein the volume control module is configured to operate the volume controlled actuator such as to steer an actuation volume of a medium for achieving adjustment of the gap distance.

The pressure controlled actuator may steer a fluid pressure for actuation, and/or the volume controlled actuator may steer a volume of medium for actuation. Even if the Marx generator is located remotely, for example when the Marx generator is arranged at an electro-pulse drill head, the output can still be effectively set and/or adjusted. The pressure/volume actuator may be coupled to one or more fluid lines. For example, the pressure controlled actuator may operate pneumatically, and/or the volume controlled actuator may operate hydraulically.

The pressure controlled actuator is configured to provide an actuation (e.g. force, displacement of a surface, rotation, etc.) using pressure controlled fluid (e.g. gas). Although volume changes of the fluid can be induced by the actuator as a result of changes in the pressure of the fluid, the control is performed based on the pressure instead of the volume. Employing a fluid pressure actuator can provide a cheap and robust design, which can provide for an accurate control of the gap distance between electrodes.

The volume controlled actuator is configured to provide actuation (e.g. force, displacement of a surface, rotation, etc.) using volume controlled medium (e.g. liquid). Although pressure changes of the medium can be induced by the actuator as a result of changes in the volume of the medium. The volume controlled actuator may provide for a highly accurate control. For example, the volume controlled actuator may be configured to increase the volume of medium by means of a pump when the gap distance is to be reduced. Hence, the actuation may be performed based on volume changes (cf. volume of medium added/removed). Although, such control may result medium pressure variations (e.g. incompressible hydraulic liquid), the volume of said medium is actively/directly controlled.

In some examples, the volume controlled actuator may include a piston for displacing a volume of a medium, such as for instance a hydraulic fluid (e.g. oil). In some example, a biasing member such as a spring may be employed for pushing the piston back towards a biasing position. However, other arrangements may also be used, for instance the volume controlled actuator may include various types of pumps configured to accurately perform actuation based on the volume. For this purpose, data indicative of the volume may be actively tracked and controlled.

Optionally, the adjustment unit comprises an adjustment member which is configured to move one of the two electrodes of at least one spark gap switch with respect the other one of the two electrodes of said at least one spark gap switch.

The mechanical transmission of the actuation of the pressure controlled actuator and/or volume controlled actuator to one or more electrodes for adjusting the gap distance can be realized in various ways. The adjustment member may be coupled to the pressure/volume actuator and one of the two electrodes of the electrode pairs in the spark gap switches. The coupling between the pressure/volume actuator and electrodes of spark gap switches can be direct or indirect. For example, a beam or rigid rod may be used for transferring a linear movement. However, it is also possible to use one or more rotary members. In some examples, adjustment unit has multiple moving parts. Various mechanical arrangements are envisaged.

Optionally, the adjustment member is arranged to mechanically couple the pressure/volume actuator and a subset of electrodes of the spark gap switches, such as to allow adjustment of relative electrode pair gap distances by means of the pressure/volume actuator. One or more pressure/volume actuators may be used.

In some examples, the adjustment unit comprises a lever unit. The lever unit may include a beam or rigid rod pivoted at a fixed hinge (cf. fulcrum). The lever unit may be used for amplifying an input force provided by the pressure controlled actuator and/or volume controlled actuator in order to provide a greater output force. An accurate adjustment of the gap distance can be achieved in this way.

Optionally, the adjustment member is arranged to jointly move one of the two electrodes of each spark gap switch with respect to the other one of the two electrodes.

Advantageously, the gap distances for multiple spark gap switches can be effectively adjusted by a same actuation (cf. action) provided by the pressure controlled actuator and/or the volume controlled actuator. The adjustment may be carried out simultaneously for all the multiple spark gap switches. This not only provides for a more reliable design, but can also result in a significantly more accurate control of the gap distances. The joint adjustment can be carried out in different ways.

The gap distances of multiple (e.g. all) spark gap switches can be adjusted simultaneously by a single action.

Optionally, the adjustment member comprises a plurality of adjustment subunits, wherein each adjustment subunit is configured to individually adjust the gap distance for one or a group of spark gap switches.

In some examples, the adjustment member is arranged to individually move electrodes of spark gap switches relative to each other. In some examples, each spark gap switch (and/or one or more groups of spark gap switches) may have a dedicated adjustment subunit. Advantageously, the relative differences between desired/targeted gap distances for the spark gap switches can be easily controlled.

Optionally, the adjustment member is arranged to directly adjust the gap distance by means of the pressure controlled actuator and/or the volume controlled actuator.

A pressure/volume controlled actuator can be used for direct adjustment of the gap distance. The pressure/volume controlled actuator can provide for large actuation forces, whilst having a compact design. Hence, a cost-effective design can be obtained in this way.

A direct coupling between the pressure/volume controlled actuator and one or more members directly connected to the electrodes, for adjusting the gap distance, provides for a simple design. Such design may be more reliable and/or require less maintenance.

Optionally, the adjustment member is arranged to indirectly adjust the gap distance by means of the pressure controlled actuator and/or the volume controlled actuator, wherein the adjustment member comprises a mechanical arrangement for transferring an actuation surface displacement realized by the pressure controlled actuator and/or volume controlled actuator into an adequate adjustment of the gap distance.

The pressure/volume controlled actuator can be configured to indirectly adjust the gap distances. The mechanical arrangement may be configured to provide an indirect connection between the pressure/volume controlled actuator and electrodes of spark gap switches of the Marx generator.

Optionally, the adjustment unit comprises a bellows including a surface which is resiliently responsively displaceable under the influence of pressure changes of the pressurized gas, wherein the surface is coupled to one of the two electrodes of each spark gap switch, wherein the bellows is sealed, and wherein the pressure controlled actuator is configured to control the fluid pressure inside the sealed bellows.

The pressure controlled actuator may be configured to regulate the pressure inside the sealed bellows. For example, in order to decrease the gap distance, the pressure inside the sealed bellows may be increased. The increase of the pressure inside the bellows may be induced by a fluid flow towards the inside of the bellows. Instead of performing active control based on volume, the pressure actuator is configured to carry out active control by monitoring and controlling the pressure.

The pressure controlled actuator is configured to provide for actuation which results in a change of the gap distance based on direct/active control of the pressure inside the bellows. In this way, the gap distance can be accurately adjusted in a robust way.

The used gas in the bellows may be a gas under pressure which is less sensitive to temperature variations for example. If the pressure of the pressurized gas between the electrodes of the spark gap switches drops (e.g. loss of gas due to leaking), one side of the bellows may expand forward and thereby adjust and increase the gap distance between the electrodes of the spark gap switches. If the pressure of the pressurized gas between the electrodes of the spark gap switches rises (e.g. temperature increase), one side of the bellows may contract backwards and thereby adjust and decrease the gap distance between the electrodes of the spark gap switches. Such passive adjustment obtained by means of the bellows can be calibrated such that the distance between said electrodes are adjusted so as to keep the breakdown voltage within a predetermined range or substantially constant, even under changing conditions related to the pressure of the pressurized gas. The bellows can provide for a passive compensation. Advantageously, in addition to the passive compensation, also an active control of the output voltage of the Marx generator is achieved using the pressure controlled actuator. The fluid pressure inside the bellows can be actively controlled using the pressure controlled actuator, wherein the pressure controlled actuator is configured to steer the fluid pressure within the bellows.

It will be appreciated that the bellows may be considered as a reversibly expandable body. Various alternative embodiments are envisaged.

Optionally, the bellows is configured such that compression and expansion of the bellows results in linear movement of a rod connected to the surface of the bellows, and wherein the rod is coupled to a shaft, wherein the adjustment unit is arranged such that movement of the rod results in pivotal movement of the shaft, and wherein one of the two electrodes of each spark gap is connected to the shaft.

Optionally, the bellows is a vacuum bellows comprising a biasing member, tensioned between the surface and a wall of the bellows.

Optionally, the biasing member is a spring, wherein a biasing force induced by the spring is adjustable.

Optionally, the rod is coupled to the shaft via a hinge connection, wherein the position of the hinge connection is adjustable.

Optionally, the medium utilized in the volume controlled actuator is a substantially incompressible medium. Various substantially incompressible mediums (e.g. liquids) can be used.

Optionally, the medium is a hydraulic liquid, such as an oil. Various hydraulic fluids may be used by the volume controlled actuator.

Optionally, the adjustment unit is configured to adjust the gap distance such as to obtain breakdown voltage at a selected potential difference for resulting in a controlled output voltage.

Advantageously, in some example, the output voltage can be set based on the available input power to the Marx generator.

According to an aspect, the invention provides for a method of operating a Marx generator, wherein the Marx generator comprises a circuit which includes at least two capacitors which are arranged to be charged in parallel and to be discharged in series, wherein during discharge an output voltage is generated adding up a charging voltage of each of the at least two capacitors, wherein the circuit comprises at least two spark gap switches, wherein each spark gap switch comprises two electrodes separated by a gap distance which is filled with a pressurized gas, and wherein each spark gap is configured such as to allow an electric spark to pass between the electrodes in case a potential difference between the electrodes exceeds a breakdown voltage, wherein the method includes providing an adjustment unit for adjusting the gap distance between the two electrodes of each of the at least two spark gap switches such as to control the output voltage, wherein the adjustment unit is configured to adjust the gap distance by means of a pressure controlled actuator and/or volume controlled actuator.

The output of the Marx generator can be effectively tuned by adjusting the gap distance between the electrodes using the pressure controlled actuator and/or volume controlled actuator. The gap distance can be changed in various ways. The relative distance between the electrodes may for example be adjusted using a linear movement, an axial movement, a radial movement, or any other type of movement.

According to an aspect, the invention provides for an electro-pulse drilling system comprising a Marx generator according to the invention, wherein the electro-pulse drilling system comprises a controller for operating the Marx generator such as to output a controlled output voltage.

In some examples, a pneumatic (pressure) line and/or a hydraulic line may be guided towards the Marx generator for providing a pressurized fluid to the pressure controlled actuator and/or a medium (e.g. hydraulic oil) to the volume controlled actuator.

Optionally, the controlled output voltage is selected based on sensory data obtained by means of a sensory unit, wherein the sensory unit is configured to measure one or more values indicative of or associated to properties of the surface to be drilled, wherein preferably the sensory unit is configured at the electro-pulse drilling head of the electro-pulse drilling system such as to enable online measurements during drilling.

In this way, the output of the Marx generator of the electro-pulse drilling system can be dynamically adjusted depending on surface (e.g. rock) to be drilled. Advantageously, the efficiency of the drilling operation can be significantly enhanced. In this way, a more cost-effective drilling operation can be carried out.

Optionally, the controlled output voltage is adjusted based on a value indicative of the drilling speed achieved by the electro-pulse drilling system.

The gap distances can be adjusted by the pressure/volume actuator based on the drilling results achieved by the electro-pulse drilling system. For example, if the drilling speed reduces, the output of the Marx generator may be adjusted in order to increase the drilling speed again. In some examples, in this way, the drilling speed can be maintained in a predetermined range (e.g. substantially constant).

Optionally, the output voltage can be set based on the available input power to the Marx generator.

According to an aspect, the invention provides for an adjustment unit for use in a Marx generator.

According to an aspect, the invention provides for an actively actuated power stabilizer for use in a Marx generator.

According to an aspect, the invention provides for a use of the Marx generator in an electro-pulse drilling system.

According to an aspect, the invention provides for an apparatus comprising a Marx generator system according to the disclosure.

It will be appreciated that the Marx generator may be a spark gap switched high voltage generator comprising a plurality of capacitors which are arranged such as to allow charging in parallel and discharging in series.

The circuit of the Marx generator may be configured such that during charging the at least two capacitors are charged, and such that discharging occurs between the at least two spark gap switches resulting in the at least two capacitors to be connected in series, such that an output voltage is generated by adding up the charging voltage of each of the at least two capacitors. The spark gap switches may be configured to operate in a self-breakdown mode.

It will be appreciated that any of the aspects, features and options described in view of the Marx generator apply equally to the method and the described electro-pulse drilling system. It will also be clear that any one or more of the above aspects, features and options can be combined.

### BRIEF DESCRIPTION OF THE DRAWING

The invention will further be elucidated on the basis of exemplary embodiments which are represented in a drawing. The exemplary embodiments are given by way of non-limitative illustration. It is noted that the figures are only schematic representations of embodiments of the invention that are given by way of non-limiting example.

In the drawing:
Fig. 1a, 1b show a schematic diagram of an embodiment of a system;
Fig. 2 shows a schematic diagram of an embodiment of a system;
Fig. 3 shows a schematic diagram of an embodiment of a system;
Fig. 4a, 4b show a schematic diagram of an embodiment of a system;
Fig. 5 shows a schematic diagram of an embodiment of a system;
Fig. 6 shows a schematic diagram of an embodiment of a system;
Fig. 7a, 7b show a schematic diagram of an embodiment of a system;
Fig. 8 shows a schematic diagram of an embodiment of a system;
Fig. 9 shows a schematic diagram of an electro-pulse drill head; and
Fig. 10a, 10b show a schematic diagram of an electro-pulse drill head.

### DETAILED DESCRIPTION

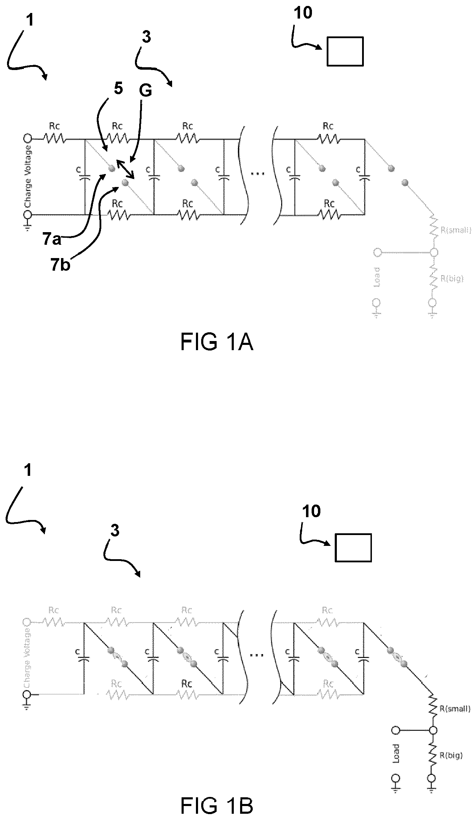

Fig. 1a, 1b show a schematic diagram of an embodiment of a system 1. The system 1 comprises a Marx generator 3 comprising a circuit that includes at least two capacitors C which are arranged to be charged in parallel and to be discharged in series, wherein during discharge an output voltage is generated adding up a charging voltage of each of the at least two capacitors C, wherein the circuit comprises at least two spark gap switches 5, wherein each spark gap switch comprises two electrodes 7a, 7b separated by a gap distance G which is filled with a pressurized gas, and wherein each spark gap switch 5 is configured to allow an electric spark to pass between its at least two electrodes 7a, 7b in case a potential difference between said two electrodes exceeds a breakdown voltage, and wherein the Marx generator includes an adjustment unit 10 which is configured to adjust the gap distance between the two electrodes of each of the at least two spark gap switches such as to control the output voltage, wherein the adjustment unit 10 is configured to adjust the gap distance by means of a pressure controlled actuator and/or volume controlled actuator.

Fig. 1a shows the Marx generator in charging state, and fig. 1b shows the Marx generator in discharging state, providing an output pulse. The circuit of the Marx generator which includes a series of capacitors C that are charged in parallel and discharged in series may have other configurations. When the capacitors C are charged, no current flows through the resistors R. If the voltage is sufficiently high, a spark can be generated between the electrodes of the spark gap switches, resulting in a series connection of the capacitors C in the circuit (see fig. 1b). The electrical current then flows from one capacitor C to the next capacitor C and so on for the subsequent stages/branches in the circuit, resulting in a high voltage pulse at the output of the Marx generator. The output is arranged at the end of the circuit. The Marx generator enables generating high voltage sparks and can be used for a wide range of applications (e.g. electric pulse drilling).

The distance between electrodes of the spark gap switches determines the breakdown voltage, i.e. the voltage required for triggering a spark between said electrodes.

The adjustment unit 10 can be employed for actively adjusting the output from the Marx generator. For instance, the adjustment/setting of the output may be carried out based on the input power provided to the Marx generator. Additionally or alternatively, the output may be adjusted dynamically based on sensory data (e.g. for the application of electro-pulse drilling).

In some examples, the adjustment unit 10 can be employed for actively compensating for effects resulting from changes in pressure of the pressurized gas. By compensating for parameters which result in a change of the pressure of the pressurized gas, it is possible to get a more stable output from the Marx generator. The value of the breakdown voltage determines the output voltage / output power of the Marx generator. Advantageously, the breakdown voltage is kept within a desired predetermined range (e.g. constant) by keeping the pressure of the pressurized gas within a desired predetermined range. In some advantageous examples, this is performed by adjusting the distance of the electrodes which affects the breakdown voltage. This allows for easy and reliable control of the breakdown voltage. Moreover, such adjustment mechanism can have a relatively simple design, making the Marx generator cheaper and less prone to errors.

In order to keep the Marx generator compact and stable, it may have a housing that is filled with a gas under pressure, such as for instance nitrogen gas under pressure. However, other dielectric gases may also be used, such as for instance air, CO2 gas, a noble gas, or mixtures of gases. By employing higher pressures, it is possible to have a compacter design of the Marx generator, since it is possible to obtain a greater breakdown voltage with smaller dimensions.

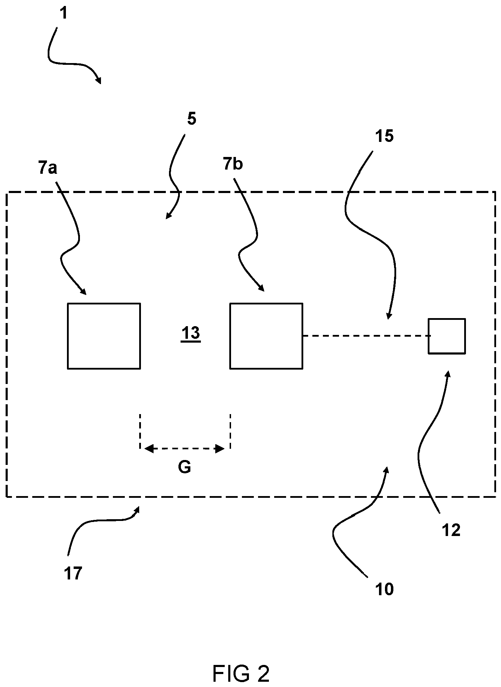

Fig. 2 shows a schematic diagram of a part of a system 1 comprising a Marx generator 3 with an adjustment unit 10. The adjustment unit 10 comprises an adjustment mechanism configured to adjust the gap distance G between the two electrodes 7a, 7b of each of the at least two spark gap switches 5. The gap distance G can define a space which is filled with a pressurized gas 13. The adjustment unit 10 comprises at least one of a pressure control module or a volume control module, wherein the pressure control module is configured to operate the pressure controlled actuator such as to steer a fluid actuation pressure for achieving adjustment of the gap distance, wherein the volume control module is configured to operate the volume controlled actuator such as to steer an actuation volume of a medium for achieving adjustment of the gap distance. In this example, the adjustment unit 10 comprises an adjustment member 15 which is configured to move one of the two electrodes of at least one spark gap switch with respect the other one of the two electrodes of said at least one spark gap switch. Advantageously, the adjustment member 15 is moved by means of a pressure/volume controlled actuator 12. The adjustment member 15 provides for a mechanical coupling between the pressure/volume actuator 12 and one of the two electrodes 7b of the at least two spark gap switches 5 of the Marx generator. In this example, the Marx generator may comprise a housing 17 in which an atmosphere of a dielectric gas prevails. The plurality of capacitor stages of the Marx generator may be arranged in said housing 17.

The Marx generator may operate more reliably and a specific power output can be set/adjusted in an effective way. Additionally, the durability of the Marx generator can be improved, even at high repetition rates, since the breakdown voltage can be better actively controlled (for example kept constant or within a predetermined range, e.g. +- 40 percent, +-30 percent, +-20 percent of a target value).

In some examples, the mechanical adjustment of the distance between electrodes of the spark gap switches can be based on sensory measurement signals. Various types of sensors can be used. For example, sensory signals may be used which are indicative or related to the pressure of the pressurized gas for maintaining the output of the Marx generator within a desired predetermined range.

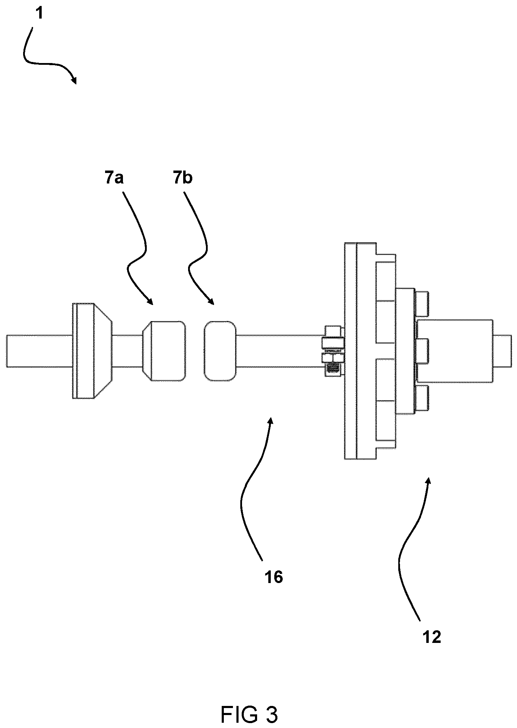

Fig. 3 shows a schematic diagram of a side view of an embodiment of a part of a system 1 including a Marx generator 3 having an adjustment unit 10 with an adjustment member adapted to adjust the gap distance G between the two electrodes 7a, 7b of each of the at least two spark gap switches 5, wherein the adjustment unit 10 is configured to adjust the gap distance by means of a pressure controlled actuator 12 and/or volume controlled actuator 12. Similar as in the embodiment shown in fig. 2, the space defined by the gap distance G can be filled with a pressurized gas 13.

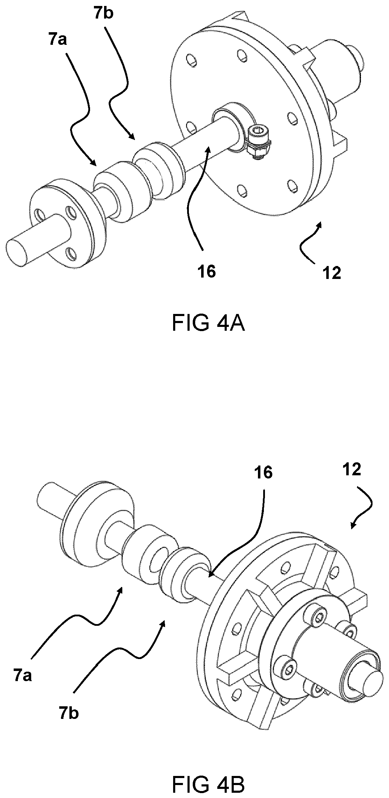

The adjustment unit 10 comprises a pressure/volume controlled actuator 12 configured to steer a fluid actuation pressure and/or a medium actuation volume so as to perform adjustment/setting of the desired gap distance G for obtaining a desired output. In this example, the pressure/volume actuation is configured to move one of the two electrodes of at least one spark gap switch with respect the other one of the two electrodes of said at least one spark gap switch by means of a rigid rod 16. Various other mechanical transmission elements can be used for this purpose. The adjustment member 15 of the adjustment unit 10 may provide for a direct or indirect mechanical coupling between the pressure/volume actuator 12 and one of the two electrodes 7b of the at least two spark gap switches 5 of the Marx generator. Fig. 4a, 4b show a schematic diagram of an embodiment of a system 1 as illustrated in fig. 3 in perspective view.

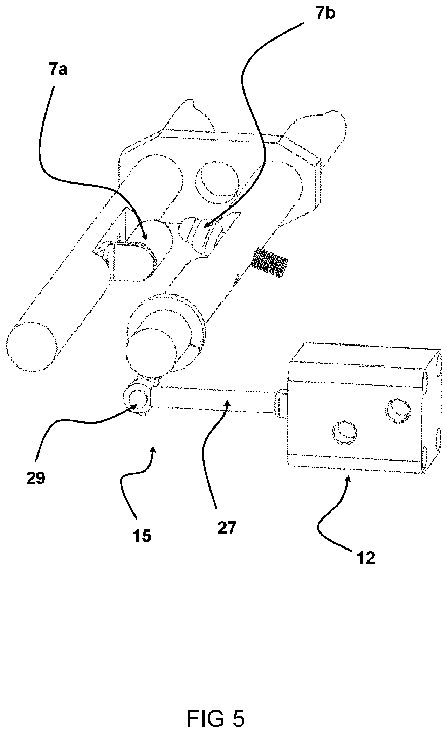

Fig. 5 shows a schematic diagram of an embodiment of a part of a system 1 comprising an adjustment unit 10 configured to adjust the gap distance by means of a volume controlled actuator 12. The volume controlled actuator 12 is configured to provide for a volumetric control with a hydraulic cylinder. Alternatively or additionally, it is also possible to employ a pressure controlled actuator 12.

The adjustment member 15 is arranged to jointly move one of the two electrodes of each spark gap switch with respect the other one of the two electrodes. Further, in this example, the adjustment member 15 is arranged to indirectly adjust the gap distance by means of the volume controlled actuator. A mechanical arrangement is provided for transferring an actuation surface displacement realized by the volume controlled actuator into a desired adjustment of the gap distance G. In this example, the gap distance G can be considered as the shortest distance between the two electrodes, as the electrodes are pivoted relative to each other and have a convex surface. Various other shapes and configurations are envisaged.

In this example, the system 1 is configured such that a displacement of a surface of the volume controlled actuator induces a movement of a rod 27 connected to said surface. The rod 27 is coupled to a shaft 29, wherein the adjustment unit is arranged such that movement of the rod 27 results in pivotal movement of the shaft 29, and wherein one of the two electrodes of each spark gap is connected to the shaft 29. Electrodes 7b of multiple spark gap switches of the Marx generator can be jointly moved by pivotal movement of said shaft 29.

In this example, the medium utilized in the volume controlled actuator can be (substantially) incompressible. For example, a hydraulic liquid such as oil may be utilized. A highly accurate control over the movement, the gap distance G and thus the output of the Marx generator can be obtained in a robust, cost-effective and accurate way.

The volume controlled actuator is configured to provide for actuation which results in a change of the gap distance based on direct/active control of the volume of medium. For example, the volume controlled actuator may include a piston for realizing a volume displacement of medium by means of which the gap distance can be controlled.

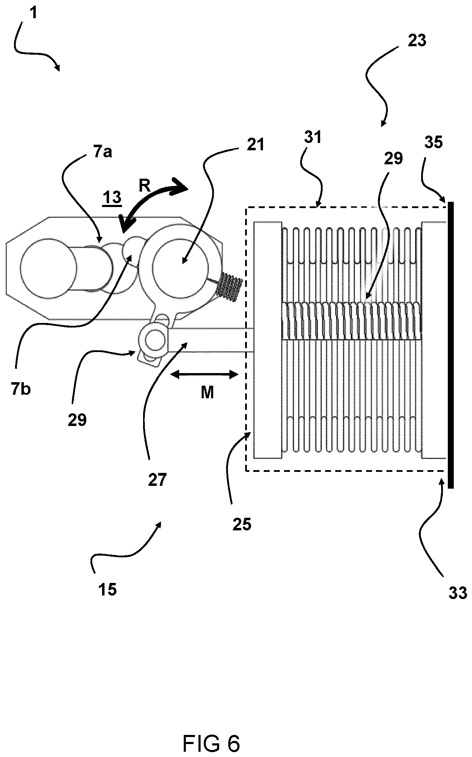

Fig. 6 shows a schematic diagram of a part of a system 1. The adjustment member 15 comprises an adjustment element 21 that is arranged to jointly move one of the two electrodes 7b of each spark gap switch 5 with respect the other one of the two electrodes 7a. The adjustment member 15 comprises a bellows 23 including a surface 25 which is resiliently responsively displaceable under the influence of pressure changes of the pressurized gas 13, wherein the surface is coupled to one of the two electrodes 7b of each spark gap switch 5.

The bellows 23 can be configured such that compression and expansion of the bellows 23 results in linear movement M of a rod 27 connected to said surface 25 of the bellows 23. The rod 27 can be coupled to a pivotally arranged shaft 21. The adjustment mechanism 11 can be arranged such that movement of the rod 27 results in pivotal movement of the shaft 21, indicated by rotation R in the figure. One of the two electrodes 7b of each spark gap 5 is connected to the shaft 21, so that the gap distance can be effectively and reliably adjusted. In this way, a joint movement can be easily obtained for adjusting the gap distance G based on the pressure change of the pressurized gas 13.

In this example, the rod 27 is coupled to the pivotally arranged shaft 21 via a hinge connection 29. The hinge connection 29 is configured such that the position of the connection point is adjustable.

In this example, the bellows 23 is filled with a pressurized fluid. Further, the bellows 23 comprises a biasing member 29 (e.g. internal compression spring), tensioned between the surface and a wall of the bellows 23. Different kinds of biasing members may be employed. Different fluid pressures may be used in a chamber/enclosure 31 of the bellows 23. The bellows has another surface 33 at its other end which is fixed, for example mounted on a wall or surface 35. The biasing member may have an adjustable biasing force, for instance using one or more other biasing members for inducing a counter force.

Such embodiments of the disclosure allow adjustment of the gap distances for all the spark gap switches at the same time (simultaneously) without requiring a dedicated for each of the spark gap switches. A more reliable arrangement is obtained in this way. Additionally, the design of the adjustment unit 10 can be significantly simplified. For example, the multiple spark gap switches may not all have a same initial/reference gap distance, for example minimal distance between the electrodes (e.g. set by using set plates therebetween). For example, the initial/reference gap distance may be in a range between 1 and 1.5 mm for the multiple spark gap switches. For instance, the first spark gap switch in the first stage may have an initial gap distance of 1.2 mm, the second spark gap switch in the second stage may have an initial gap distance of 1.1 mm, the third spark gap switch in the third stage may have an initial gap distance of 1.4 mm, etc. By jointly changing adjusting the gap distances for the multiple spark gap switches, for example by performing a pivotal movement of the pivotally arranged shaft, the relative initial gap distances may be respected. A standard distance between electrodes of the individual spark gap switches can remain the same, however, the change of the gap distance may be the same for each of said multiple spark gap switches.

Furthermore, if the gap distance for the spark gap switches changes under the influence of vibrations, this can also have the effect of changing the breakdown voltage(s) and thus the output power of the Marx generator. Advantageously, such a mechanical arrangement of adjusting the gap distances is less sensitive to vibrations. In this way, a reliable power stabilizer can be obtained which can effectively ensure that a preset power will be maintained during use of the Marx generator (e.g. during the entire drilling process for electro-pulse drilling).

The adjustment unit 10 is configured to adjust the gap distance by means of a pressure controlled actuator and/or volume controlled actuator. A fluid line may be provided to the housing of the Marx generator for the pressure/volume controlled actuator 12. Advantageously, the gap distance may be adjusted pneumatically (cf. gas) or hydraulically (cf. liquid medium) using the pressure/volume controlled actuator 12.

In this example, the bellows comprises a (hermetically) sealed housing/container such that the fluid pressure inside the bellows can be regulated using the pressure actuator. A reliable and robust control arrangement can be achieved in this way.

The extent to which the distance between the electrodes changes as a function of a pressure variation of the pressurized gas can be adjusted by changing the pressure inside the bellows. By actively changing the pressure inside the bellows, a desired overcompensation or desired overcompensation can be obtained. As a result, a pressure variation within the bellows can also cause a power variation. Therefore, advantageously, the bellows can be employed as an output power regulator. Additionally or alternatively, also the mechanical arrangement that is configured to convert a stroke displacement into a gap distance change may be tuned for adjusting said extent to which the distance between the electrodes changes.

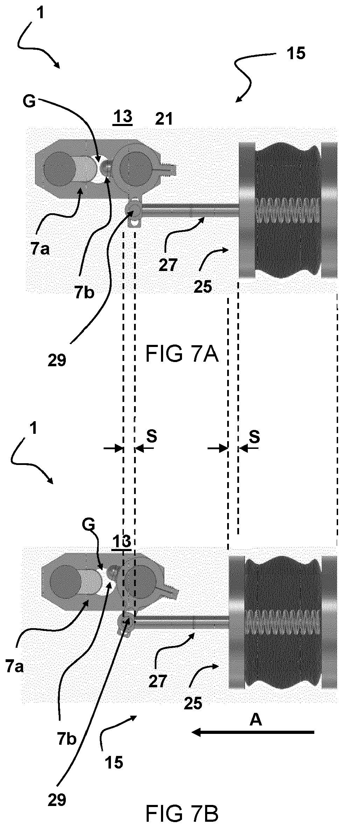

Fig. 7a, 7b show a schematic diagram of a part of a system 1. Different states of the adjustment arrangement shown in the example of fig. 6 are illustrated. Fig. 7a shows a first state in which the gap distance between the first and second electrodes 7a, 7b of the spark gap switch is minimal. Fig. 7b shows a second state in which the moveable surface 25 of the bellows 23 has been displaced by means of the pressure/volume controlled actuator 12. As a result, a linear stroke displacement S of the rod 27 is achieved resulting in a pivotal movement of the shaft 21, thereby increasing the gap distance G.

One of the two electrodes of each spark gap switch may be mounted on a pivotally arranged shaft 29 (e.g. cylindrical shaft). The electrode on the pivotally arranged shaft 29 may have a spherical head. A pivotal movement of the pivotally arranged shaft can result in a changing distance between the two electrodes of the spark gap switches.

If the pressure of the pressurized gas increases, the moving surface 25 of the bellows 23 is pulled back, and the pivotally arranged shaft rotates counter clockwise, and the electrode(s) arranged on said pivotally arranged shaft are positioned closer to the other electrode(s) arranged of the spark gap switch(es). As a result, the distance between the electrodes of the spark gap switch(es) becomes smaller in predictable way (cf. calibration), resulting in a shorter path to be travelled by a spark between the (at least) two electrodes. Advantageously, a reliable and accurate passive mechanical adjustment mechanism can be obtained, which is less prone to errors. For example, in some applications, electronics may fail or would require extensive shielding due to an aggressive electromagnetic interference (EMI) environment. Additionally, the adjustment unit 10 of the system 1 is configured to actively adjust the gap distance by means of a pressure controlled actuator which changes the fluid pressure inside the bellows. The fluid pressure in the bellows is thus adjustable such as to actively control the output power of the high voltage generator. For example, a pressure line may be coupled to the bellows through which the pressure inside the bellows can be changed over time. For example, the pressure inside the bellows maybe increased, decreased or maintained in order to adjust/set the distance between electrodes of the spark gap switches, which in turn affect the output power of the voltage generator. For instance, when the high voltage generator is used in electro-pulse drilling, some surfaces (e.g. particular rock) may require a different output power for performing efficient and/or effective drilling. Additionally or alternatively, the speed of the drilling can also be controlled in this way, without requiring electrical actuators at the electro-pulse drill head. Controlling the pressure inside the bellows for adjusting the output power of the high voltage generator (cf. Marx generator) may provide for a pneumatic control which is beneficial in various applications. Electronic equipment may require excessive shielding or may be more prone to errors due to the relatively harsh conditions at the drill head during for example during the electro-pulse drilling process (cf. EMI, vibrations, high temperatures, etc.). For example, by changing the gas pressure (e.g. vacuum pressure) in the bellows, the distance between the electrodes can be accurately changed, and the output power can be effectively varied as desired.

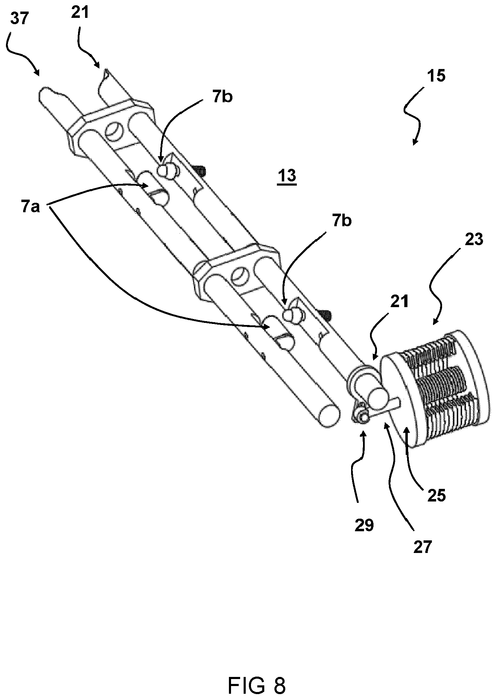

Fig. 8 shows a schematic diagram of a part of a system 1 in perspective view. The adjustment member 15 is configured for jointly adjusting the distance between electrodes of multiple spark gap switches 5. The rotation of the shaft 21 results in joint relative movement of the electrodes 7a, 7b of the multiple spark gap switches 5.

The distance between the electrodes 7a, 7b of each of the spark gap switches 5 in the multiple stages of the Marx generator can be adjusted together using a single action. Each stage has a spark gap switch which may require a particular initial distance. The one of the two electrodes of the multiple spark gap switches of the multiple stages may be mounted on the pivotally arranged shaft. In this way, the distance between electrodes of each of the multiple spark gap switches can be jointly adjusted, whilst respecting the initial distance between electrodes for each of the multiple spark gap switches. The initial distance may be a result of calibration for example. With other words, the electrode distance of the multiple spark gap switches can be adjusted with one movement. This provides for a highly reliable adjustment mechanism for compensating for the effects resulting from changes in pressure of the pressurized gas.

Advantageously, the adjustable spark gap switches may provide for increased reliability, repetition rate, and lifetime. The time required between maintenance cycles can be increased, resulting in a more cost-effective design.

Optionally, a vacuum bellows is employed for achieving a passive compensation. As a result, advantageously, the operation of the bellows is no longer dependent on changes of the surrounding/ambient temperature which would cause pressure changes of the gas inside the bellows. However, additionally, the output of the Marx generator can be actively controlled by regulating the (vacuum) pressure inside the bellows. Advantageously, adjustment of the pressure inside the bellows can be achieved by means of the pressure controlled actuator.

The breakdown voltage in function of the pressure of the pressurized gas for different gases can be given in a Paschen's law graph. At constant temperature in a uniform field, the sparking potential of gas depends only upon the product of gas pressure and electrode spacing. With other words, the sparking potential is function of the product of both pressure and distance and is neither dependent on pressure alone nor distance alone, i.e. Vₛ = f(pd). Such Vₛ-pd curve can be given for different gases. Different dielectric gases can be employed in the Marx generator.

The curve has a left branch and a right branch. The right branch is substantially linear and allows for accurate control, for example for keeping the breakdown voltage substantially constant or within a predetermined range (e.g. +-10 percent from an initial value), even under changing parameters which can influence the pressure of the fluid between the electrodes of the spark gap switches. It is advantageous to use such linear part in control. As can be seen, for lower pressures, the graph is relatively steep, thus making it very sensitive to changes, resulting in a more difficult or even unreliable control in those ranges. In the figure, For example, for nitrogen gas at a pressure of 12 bar, the breakdown voltage is approximately 17 kV/mm.

If the pressure of the pressurized gas rises, the breakdown voltage rises. This can be actively compensated for by means of the adjustment unit 10 by reducing the distance between the electrodes of the spark gap switches, using the pressure/volume controlled actuator.

It will be appreciated that, in some examples, in contrast to joint adjustment, the adjustment member may have a plurality of adjustment subunits, wherein each adjustment subunit is configured to individually adjust the gap distance for one or a group of spark gap switches.

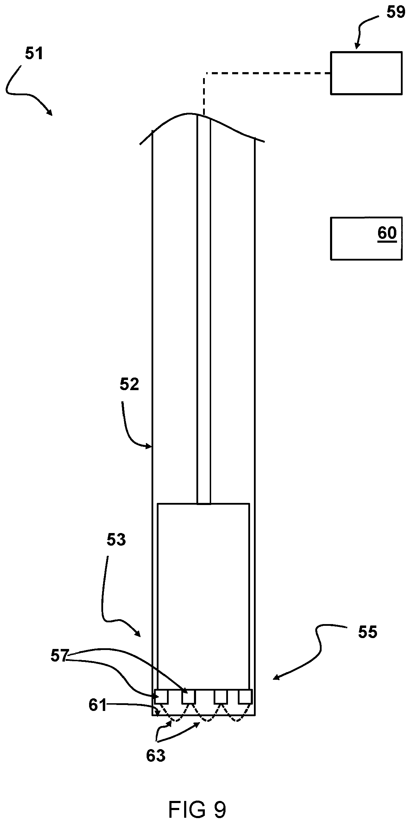

Fig. 9 shows a schematic diagram of an embodiment of an electro-pulse drilling system 51. The drilling system 51 comprises a controller 60 configured for operating the electro-pulse drilling system. The system 51 comprises a drill head 53 with an end portion 55, wherein at least two electrodes 57 are arranged at the end portion 55 of the drill head 53. The system 51 further includes an actuation system 59 configured for moving the drill head adjacent to the surface 61 to be broken up. The system 51 also includes a high voltage generator configured for applying a voltage between the electrodes 57 resulting in one or more electric discharges between the electrodes 57, the one or more discharges resulting in one or more electric arcs 63 for breaking up the surface 61. The high voltage generator is a Marx generator.

In the shown example, the drill head 53 is positioned in a drill hole 52. In some cases the voltage generated (not shown in this figure) is separated from the drill head 53. However, it is also envisaged that the voltage generator is attached to or integrated in the drill head of the drilling system 51. In some examples, the drill head 53 and the voltage generator form a unitary device, directly coupled to each other. In some examples, the drill head 53 and the voltage generator are separated and can be positioned remotely with respect to each other, for instance coupled by means of wiring. In some examples, the drill head 53 and the voltage generator are separated such as to allow movement with respect to each other. Many types of arrangements are possible.

It will be appreciated that the front end of the drill head 53 is not necessarily a flat face containing electrodes 57 extending therefrom. The front end may only include protruding electrodes (e.g. rods with electrode end portions). Between the protruding electrodes 57, sufficient spacing may be provided to as to allow debris to be evacuated by means of flushing.

An electro-pulse drilling installation with a Marx high voltage generator may require that the components of the Marx generator are built into in a closed housing which is filled with a gas at a preset pressure (e.g. dry nitrogen gas under pressure). The preset pressure may be chosen sufficiently high in order to keep the dimensions of the housing limited. The pressure of the pressurized gas in the housing determines the breakdown voltage (kV/cm) and therefore also the mutual distance between the various components. A higher pressure of the pressured gas results in higher breakdown voltage for the spark gap switches. Additionally, the spark gap switches may be arranged in a same housing in which the pressurized gas prevails. Advantageously, the adjustment unit 10 is provided for adjusting the output of the Marx generator by changing the electrode gap distance(s) in the Marx generator, wherein the adjustment unit is configured to adjust the gap distance by means of a pressure controlled actuator and/or volume controlled actuator. In some advantageous examples, the gap distance is adjusted in order to achieve breakdown (cf. triggering of the spark gap switches) at a certain breakdown voltage. The spark gap switches can also be mounted in a separate housing (e.g. one or more tubes) with a separate pressurized gas (e.g. all at same or different pressures).

The Marx generator may be integrated into the electro-pulse drill head body or built externally. In both cases, the active adjustment unit according to the disclosure may be arranged in the Marx generator.

The breakdown voltage of the spark gap switches may be determined by the gas pressure, and thus the available power output of the Marx generator at the electro-pulse drill head also depends on this. Furthermore, the gas pressure of the pressurized gas also depends on the temperature of the pressurized gas. The temperature of the pressurized gas in the electro-pulse drill head may change significantly during (deep) electro-pulse drilling operations (e.g. due to geothermal heat), which can significantly change the breakdown voltage(s) and thus the output power. The adjustment unit according to the disclosure enables to actively compensate for this and can prevent such changes of the breakdown voltage(s) and the output power. Additionally, a passive adjustment obtained by a compensation unit can also be provided, which for example will compensate the gap distance based on a pressure change, temperature change, etc. In this way, the output can be retained in a predetermined range (e.g. substantially constant) passively by the compensation unit. However, if desired, the adjustment unit allows to actively set/adjust the output voltage using the pressure/volume controlled actuator. In some examples, it is also possible that the adjustment unit is configured to actively compensate and retain the output of the Marx generator in said predetermine desired range.

The adjustment unit 10 according to the disclosure can provide for an effective and reliable output control of the Marx generator. Pressure changes of the pressurized gas at the electrodes of the spark gap switches in the Marx generator in the housing(s) can be captured and actively compensated for. For this purpose one or more sensors may be used which can capture indicative of the pressure of the pressurized gas. In some examples, the gap distance between the electrode pairs of the spark gap switches is adjusted using the pressure/volume controlled actuator based on said changing pressures. For example, the pressure changes may be induced as a result of loss of gas over time from the Marx generator (e.g. leak, bad packaging, etc.); temperature changes of the gas in the Marx generator for instance due to environmental conditions; and/or any other cause.

In some examples, the adjustment unit comprises a bellows according to the disclosure. In some examples, the bellows is a bellows with a gas chamber. Optionally, the gas chamber is in fluid communication with an external unit by means of a fluid line. For example, the line may be connected to a pump for controlling the fluid pressure inside the bellows (cf. pressure controlled actuator). One side of the bellows may be fixedly mounted on a structure. The other side may be allowed to move. In the chamber of the bellows, a compression spring may be mounted. A biasing force of the compression spring can be adjusted to a reference gas pressure in the Max generator. The expansion or compression of this compression spring may be tuned such that a linear movement of the other side is obtained when the pressure is changed within a predetermined pressure range.

By using vacuum in the bellows (cf. significant under pressure), tuning and setting of the bellows becomes easier and substantially independent of ambient temperatures. Therefore, a more predictable and reliable adjustment mechanism can be obtained in this way. By means of the pressure controlled actuator active control of the gap distance can be achieved. The compression or expansion of the bellows may be substantially linearly transferred with a rod to an eccentric rotating shaft. One electrode of the spark gap switch may be mounted on this rotating shaft. This rotating shaft increases or decreases the opening of the spark gap switch(es) (cf. gap distance between its electrodes) based on the gas pressure of the pressurized gas surrounding said spark gap switch(es). The adjustment can be performed jointly by arranging one electrode of multiple spark gap switches on this rotating shaft. The rotation of the rotating shaft results in a joint movement of one of the electrodes of the multiple spark gap switches. Advantageously, in such examples, a passive compensation can be achieved. The active control (active adjustment/compensation) can be achieved using the pressure controlled actuator which may change the fluid pressure inside the bellows for example by means of external piping or fluid communication.

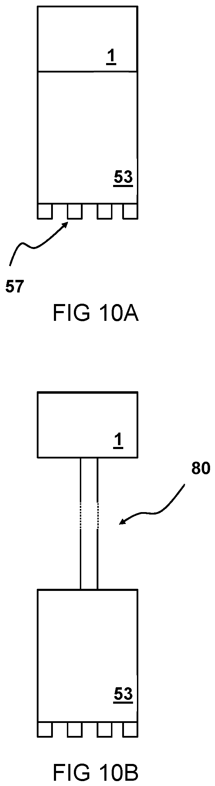

Fig. 10a and 10b show a schematic diagram of an embodiment of drill head 53. In fig. 10a, a Marx generator system 1 is integrated within the drill head 53. In fig. 10b, the Marx generator system 1 is distanced from the drill head 53. The distance between the voltage generator 1 and the drill head 53 may be adjustable in this example, for example the distance may be increased when the drill head 53 is lowered further in the bore hole during the electro-pulse drilling process. The voltage generator 1 and the drill head 53 may be coupled by means of a coupling member 80.

The pressure of the pressurized gas can increase for example due to geothermal energy at certain depths. It is also possible that the temperature changes due to the operation of the electro-pulse drilling head. For example, internal heating can also affect the temperature of the pressurized gas. An increased pressure resulting from an increased temperature will cause an increase of the breakdown voltage(s). Without the adjustment unit according to the disclosure, at a certain point the electro-pulse drilling head would stop working. Therefore, by employing the method and system according to disclosure, the electro-pulse drilling head with Marx generator can be employed for greater depths, actively countering detrimental effects a.o. resulting from geothermal heating using the adjustment unit configured to adjust the gap distance by means of a pressure controlled actuator and/or volume controlled actuator..

By employing higher pressures for the pressurized gas, a more compact design can be achieved. In this way, for example smaller electro-pulse drilling heads can be obtained. However, larger pressures may be more sensitive to effects such as temperature changes, gas leaks, etc. Various gases can be employed in the Marx generator. The gas may be a dielectric gas. For example, the gas may be dry nitrogen gas (cf. highly electrically insulating gas). However, it is also possible to use other gases (e.g. noble gases). In some examples, it is desired to have a gas which has a breakdown voltage larger than 1000Volt/mm at a pressure of 1 atm. Various dielectric gases can be used. Examples of other gases which can be used are argon, helium, natrium, sulphur hexa-fluoride, air, CO2 gas, etc.

In some examples, an fluid line is connected to the electro-pulse drill head in which the Marx generator is located. However, it is also envisaged that the pressure/volume controlled actuator is configured to operate without a fluid line.

It will be appreciated that various pressures can be employed inside the bellows (e.g. vacuum pressures). Optionally, the vacuum pressure is smaller than 0.1 bar. In some examples, the vacuum pressure is smaller than 0.01 bar. In some example, the effect of temperature is even further reduced by employing a vacuum pressure of 0.001 bar or even lower. The selection of the vacuum pressure may highly depend on the application in which the Marx generator is being employed. The temperature of the pressurized gas may for example be elevated to higher temperatures as a result of geothermal heat during electro-pulse drilling. The vacuum pressure may be selected such as to reduce the effect of the elevated temperatures on the stroke displacement, thereby providing for a more robust and accurate control. The vacuum pressure may be selected such that the temperature variations result in deviations which fall within the resolution of the control arrangement.

In some examples, the pressure of the bellows is related to the pressure of the pressurized gas. Optionally, the pressure inside the bellows is at least 10 times smaller than the pressure of the pressurized gas, more preferably at least 20 times smaller, even more preferably at least 30 times smaller.

It will be appreciated that a spark gap switch may be understood as a spark switch or a spark electrode switch.

It will be appreciated that electro-pulse drilling may also be understood as electrical-pulse drilling, electrical arc drilling, electro-crushing drilling, pulsed arc plasma drilling, pulsating arc drilling, plasma arc drilling, plasma pulse drilling, plasma pulse geo-drilling, etc. The term "drilling" along with its derivatives, may be replaced with "boring" and vice versa. The term can be interpreted as an action of making a hole, cutting or making an indentation or the like, in some surface or material. The term drilling or boring may imply that pieces of the surface or material are broken up and are removed from the drilling zone during the drilling process.

It will be appreciated that the gap distance may be considered as an interspace, a separation, a clearance, a split, a spacing, or a void between the electrodes of the spark gap switches.

In the following description and claims, the term "coupled" along with its derivatives, may be used. "Coupled" is used to indicate that two or more elements co-operate or interact with each other, but they may or may not have intervening physical or electrical components between them.

As used in the claims, unless otherwise specified the use of the ordinal adjectives "first", "second", "third", etc., to describe a common element, merely indicate that different instances of like elements are being referred to, and are not intended to imply that the elements so described must be in a given sequence, either temporally, spatially, in ranking, or in any other manner. The drawings and the forgoing description give examples of embodiments. Those skilled in the art will appreciate that one or more of the described elements may well be combined into a single functional element. Alternatively, certain elements may be split into multiple functional elements.

The term "about" or "approximately" as used herein when referring to a measurable value such as a parameter, an amount, a temporal duration, and the like, is meant to encompass variations of +/-10 % or less, preferably +/-5 % or less, more preferably +/- 1% or less of and from the specified value, insofar such variations are appropriate to perform in the disclosed invention. It is to be understood that the value to which the modifier "about" or "approximately" refers is itself also specifically, and preferably, disclosed.

It will be appreciated that the method may include computer implemented steps. All above mentioned steps can be computer implemented steps. Embodiments may comprise computer apparatus, wherein processes performed in computer apparatus. The invention also extends to computer programs, particularly computer programs on or in a carrier, adapted for putting the invention into practice. The program may be in the form of source or object code or in any other form suitable for use in the implementation of the processes according to the invention. The carrier may be any entity or device capable of carrying the program. For example, the carrier may comprise a storage medium, such as a ROM, for example a semiconductor ROM or hard disk. Further, the carrier may be a transmissible carrier such as an electrical or optical signal which may be conveyed via electrical or optical cable or by radio or other means, e.g. via the internet or cloud.

Some embodiments may be implemented, for example, using a machine or tangible computer-readable medium or article which may store an instruction or a set of instructions that, if executed by a machine, may cause the machine to perform a method and/or operations in accordance with the embodiments.

Various embodiments may be implemented using hardware elements, software elements, or a combination of both. Examples of hardware elements may include processors, microprocessors, circuits, application specific integrated circuits (ASIC), programmable logic devices (PLD), digital signal processors (DSP), field programmable gate array (FPGA), logic gates, registers, semiconductor device, chip sets, et cetera. Examples of software may include software components, programs, applications, computer programs, application programs, system programs, machine programs, operating system software, mobile apps, middleware, firmware, software modules, routines, subroutines, functions, computer implemented methods, procedures, software interfaces, application program interfaces (API), methods, instruction sets, computing code, computer code, et cetera.

Herein, the invention is described with reference to specific examples of embodiments of the invention. It will, however, be evident that various modifications, variations, alternatives and changes may be made therein, without departing from the essence of the invention. For the purpose of clarity and a concise description features are described herein as part of the same or separate embodiments, however, alternative embodiments having combinations of all or some of the features described in these separate embodiments are also envisaged and understood to fall within the framework of the invention as outlined by the claims. The specifications, figures and examples are, accordingly, to be regarded in an illustrative sense rather than in a restrictive sense. The invention is intended to embrace all alternatives, modifications and variations which fall within the scope of the appended claims. Further, many of the elements that are described are functional entities that may be implemented as discrete or distributed components or in conjunction with other components, in any suitable combination and location.

In the claims, any reference signs placed between parentheses shall not be construed as limiting the claim. The word 'comprising' does not exclude the presence of other features or steps than those listed in a claim. Furthermore, the words 'a' and 'an' shall not be construed as limited to 'only one', but instead are used to mean 'at least one', and do not exclude a plurality. The mere fact that certain measures are recited in mutually different claims does not indicate that a combination of these measures cannot be used to an advantage.

## Claims

1. A Marx generator comprising a circuit which includes at least two capacitors which are arranged to be charged in parallel and to be discharged in series, wherein during discharge an output voltage is generated adding up a charging voltage of each of the at least two capacitors, wherein the circuit comprises at least two spark gap switches, wherein each spark gap switch comprises two electrodes separated by a gap distance which is filled with a pressurized gas, and wherein each spark gap switch is configured to allow an electric spark to pass between its two electrodes in case a potential difference between said two electrodes exceeds a breakdown voltage, and wherein the Marx generator includes an adjustment unit which is configured to adjust the gap distance between the two electrodes of each of the at least two spark gap switches such as to control the output voltage, wherein the adjustment unit is configured to adjust the gap distance by means of a pressure controlled actuator and/or volume controlled actuator.

2. The Marx generator of claim 1, wherein the adjustment unit comprises at least one of a pressure control module or a volume control module, wherein the pressure control module is configured to operate the pressure controlled actuator such as to steer a fluid actuation pressure for achieving adjustment of the gap distance, wherein the volume control module is configured to operate the volume controlled actuator such as to steer an actuation volume of a medium for achieving adjustment of the gap distance.

3. The Marx generator of claim 1 or 2, wherein the adjustment unit comprises an adjustment member which is configured to move one of the two electrodes of at least one spark gap switch with respect the other one of the two electrodes of said at least one spark gap switch.

4. The Marx generator of claim 1, 2 or 3, wherein the adjustment member is arranged to jointly move one of the two electrodes of each spark gap switch with respect the other one of the two electrodes.

5. The Marx generator of any one of the preceding claims, wherein the adjustment member is arranged to directly adjust the gap distance by means of the pressure controlled actuator and/or the volume controlled actuator.

6. The Marx generator of any one of the preceding claims, wherein the adjustment member is arranged to indirectly adjust the gap distance by means of the pressure controlled actuator and/or the volume controlled actuator, wherein the adjustment member comprises a mechanical arrangement for transferring an actuation surface displacement realized by the pressure controlled actuator and/or volume controlled actuator into an adequate adjustment of the gap distance.

7. The Marx generator of any one of the preceding claims, wherein the adjustment unit comprises a bellows including a surface which is resiliently responsively displaceable under the influence of pressure changes of the pressurized gas, wherein the surface is coupled to one of the two electrodes of each spark gap switch, wherein the bellows is sealed, and wherein the pressure controlled actuator is configured to control the fluid pressure inside the sealed bellows.

8. The Marx generator of claim 7, wherein the bellows is configured such that compression and expansion of the bellows results in linear movement of a rod connected to the surface of the bellows, and wherein the rod is coupled to a shaft, wherein the adjustment unit is arranged such that movement of the rod results in pivotal movement of the shaft, and wherein one of the two electrodes of each spark gap is connected to the shaft.

9. The Marx generator of any one of the preceding claims 2-8, wherein the medium utilized in the volume controlled actuator is a substantially incompressible medium.

10. The Marx generator of claim 9, wherein the medium is a hydraulic liquid, such as an oil.

11. The Marx generator of any one of the preceding claims, wherein the adjustment unit is configured to adjust the gap distance such as to obtain breakdown voltage at a selected potential difference for resulting in a controlled output voltage.

12. A method of operating a Marx generator, wherein the Marx generator comprises a circuit which includes at least two capacitors which are arranged to be charged in parallel and to be discharged in series, wherein during discharge an output voltage is generated adding up a charging voltage of each of the at least two capacitors, wherein the circuit comprises at least two spark gap switches, wherein each spark gap switch comprises two electrodes separated by a gap distance which is filled with a pressurized gas, and wherein each spark gap is configured such as to allow an electric spark to pass between the electrodes in case a potential difference between the electrodes exceeds a breakdown voltage, wherein the method includes providing an adjustment unit for adjusting the gap distance between the two electrodes of each of the at least two spark gap switches such as to control the output voltage, wherein the adjustment unit is configured to adjust the gap distance by means of a pressure controlled actuator and/or volume controlled actuator.

13. An electro-pulse drilling system comprising a Marx generator according to the claims 1-11, wherein the electro-pulse drilling system comprises a controller for operating the Marx generator such as to output a controlled output voltage.

14. The electro-pulse drilling system according to claim 13, wherein the controlled output voltage is selected based on sensory data obtained by means of a sensory unit, wherein the sensory unit is configured to measure one or more values indicative of or associated to properties of the surface to be drilled, wherein preferably the sensory unit is configured at the electro-pulse drilling head of the electro-pulse drilling system such as to enable online measurements during drilling.

15. The electro-pulse drilling system according to claim 13 or 14, wherein the controlled output voltage is adjusted based on a value indicative of the drilling speed achieved by the electro-pulse drilling system.
